# EUROPEAN PATENT APPLICATION

(11) **EP 1 675 264 A2**
(43) Date of publication of application: **28.06.2006**
(21) Application number: 05257777.2
(22) Date of filing: 16.12.2005
(51) Int. Cl.: H03J 1/00

(54) **Image display device and channel setting method**

(30) Priority: 16.12.2004 KR 2004107408
(71) Applicant: LG Electronics Inc., Yongdungpo-gu Seoul (KR)
(72) Inventor: Choi, Byong Yul, buk-gu, Daegu-shi Kyoungsang-do (KR)
(74) Representative: Camp, Ronald

(57) **Abstract**

A channel setting device comprises: a signal processing unit including a tuner to perform a channel search; a key input unit to which a command of a user is input; a memory storing channel information; and a controller controlling a channel setting reference to channel information stored in the memory in performing an automatic channel setting in accordance with the key input unit and the automatic channel setting command.

The memory stores information about previously-deleted channels so that these are not stored again if a subsequent automatic channel tuning operation becomes necessary.

## Description

The present invention relates to an image display device and a channel setting method thereof. It more particularly relates to an image display device setting a channel automatically with reference to channel information, and a method thereof.

In a conventional analog TV, image quality is degraded if it is displayed on a large-sized screen, and the number of allocated channels is limited to 80 including a VHF (very high frequency) and an UHF (ultra high frequency) channel bandwidth. Therefore, analog TV has a limitation as a unidirectional medium.

To overcome the disadvantage of analog TV, digital TV was invented. A digital TV is remarkably improved in providing a good image quality, which is twice as clear as analog TV, and all the channel bandwidth which had not used can be used since there is no interference between neighboring channels.

In addition, an advantage of a digital broadcasting is to freely transmit, process, provide and maintain the contents (video, audio and data) without losing information, and digital TV can provide a variety of services.

The elements of degrading image quality such as ghosting when a broadcast signal is transmitted through the air, and a phenomenon that a color bleed in an analog broadcast system is eliminated, and a high quality image and a high quality voice may be provided by digital TV.

A high definition means a very clear resolution equivalent to 35mm movie quality, and this is called a high definition TV (HDTV). A standard definition TV (SDTV) has slightly better resolution than in current analog broadcasting, but SDTV still does not have as good a quality as the high definition, and it has a resolution equivalent to 16mm movie quality.

As the greater the number of minimum units consisting of a screen "pixel" increases, so the resolution becomes better. A HDTV has approximately 2 million pixels (resolution: 1920X1080) and a SDTV has approximately 350,000 pixels (resolution: 720X480). A high quality audio service provides CD quality sound and 3D surrounding stereo sound for movie viewers. 3D stereo sound uses 6 speakers to provide a 3D dimensional sound and a realistic sound.

Analog broadcasting systems are gradually being replaced by digital broadcasting systems because of all the advantages of a digital broadcasting system.

As the broadcasting system changes towards a digital system, the current digital TV provides an automatic channel setting that tunes an analog system and a digital system simultaneously. In other words, when an automatic channel setting is done, a state of a current input antenna is obtained to set channels automatically in the following order: an air broadcasting, a cable broadcasting, a digital TV air broadcasting, and a digital TV cable broadcasting.

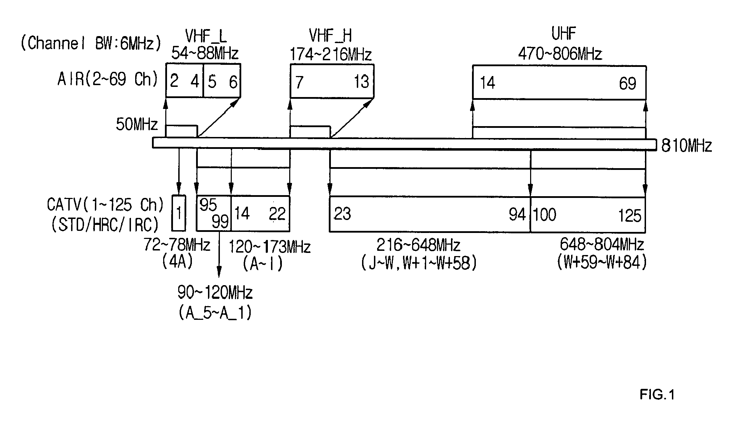

Fig. 1 is a diagram showing a frequency range of the current channels used in some parts of the world.

As shown in Fig. 1, conventional air broadcasting is allocated channels from number 2 to number 69, and cable broadcasting is allocated channels from number 1 to either number 14 or up to number 125. The existence of a synchronous signal in a frequency corresponding to each number is determined. If the signal exists, the channel is saved and if not, the channel is not saved.

A process for analyzing a synchronous signal of the channel frequency is called tuning. Through this tuning process, the channel spectrum is searched and a channel where a synchronous signal exists is saved.

Generally, a channel frequency search is done through the automatic channel setting.

For example, if a user inputs an automatic channel setting key in a remote control unit, the tuner of a digital TV searches a range of the frequency channels in series and stores these channels having a synchronous signal.

After an automatic channel setting has saved the channel, the saved channel is converted as the up/down key is input.

In the meantime, all channels including the user's unwanted channels are also stored through the above automatic channel setting process.

For example, in a case of particular channels such as cooking channel, home shopping channel, religion channel, although the user is not interested in the particular channels, the inconvenience is caused by the delay of going through each channel while switching channels up or down.

Therefore, through the automatic channel setting process, the user can delete the unwanted channels to make a faster progress in switching channels up or down.

In the meantime, even if a channel is automatically set, the automatic channel setting may be required.

However, the user might have to delete the wanted channels since all the deleted channels are saved if an automatic channel is redone.

In addition, a digital broadcasting system has a plurality of channels and broadcast signals are not always transmitted on each channel. There are many cases that an existed broadcast signal disappears, and where there was no broadcast signal, but the signal existed in the channel.

Therefore, channels having broadcast signals are searched through a periodic automatic channel setting to be stored, but unnecessary channels deleted by the user are stored again by an additional automatic channel setting as described above.

The present invention seeks to provide an improved image display device.

Embodiments of the invention can provide an image display device, which lets the user select and save his or her wanted channel depending on whether the particular channel was previously deleted in compliance with the channel information in the automatic channel setting process, and a corresponding channel setting method.

In accordance with a first aspect of the invention, a channel setting device comprises: a signal processing unit including a tuner arranged to perform a channel search; a key input unit arranged to receive as input a command of a user; a memory arranged to store channel information; and a controller arranged to control channel setting with reference to channel information stored in the memory in performing an automatic channel setting in accordance with the key input unit and the automatic channel setting command.

In accordance with another aspect of the invention, a channel setting method comprises: receiving an automatic channel setting command; searching for a channel information stored in a memory in accordance with the automatic channel setting command; and performing a channel setting with reference to the channel information.

In accordance with another aspect of the invention, a channel setting device comprises: a signal processing portion having a tuner arranged to perform a channel search; a key input unit arranged to receive a user command; and a controller arranged to perform channel storing with reference to the channel information in accordance with an automatic channel setting method in performing an automatic channel setting according to a signal of the key input portion.

In accordance with another aspect of the invention, a channel setting method comprises: receiving an automatic channel setting command; determining if the automatic channel setting command is the first automatic channel setting; and performing a channel setting with reference to a channel information stored in a memory if the automatic channel setting command is the first automatic channel setting, and performing a channel setting with reference to all the channels receiving a broadcast signal if the automatic channel setting command is not the first automatic channel setting.

In accordance with another aspect of the invention, a channel setting method comprises: receiving an automatic channel setting command performing an automatic channel setting with respect to some channels out of all the setting possible channels; searching for a channel information stored in a memory in accordance with the automatic channel setting command; and performing a channel setting with reference to the channel information with respect to a channel receiving a broadcast signal out of some channels.

In accordance with another aspect of the invention, a channel setting method comprises: receiving an automatic channel setting command; and determining if a channel information and a broadcasting information stored in a memory in accordance with the automatic channel setting command to store a selected channel out of channels having a broadcast signal.

Embodiments of the invention will now be described by way of non-limiting example only, with reference to the drawings, in which:

Fig. 1 is a brief descriptional view illustrating the frequency spectrum of currently on-air channels used in TV broadcasting:

Fig. 2 is a view describing an embodiment of an image display device in accordance with the present invention.

Fig. 3 is a flow chart describing the first embodiment of a channel settings method in accordance with the present invention.

Fig. 4 is a flow chart describing the second embodiment of a channel settings method in accordance with the present invention.

Fig. 5 is a flow chart describing the third chart describing the first embodiment of a channel settings method in accordance with the present invention.

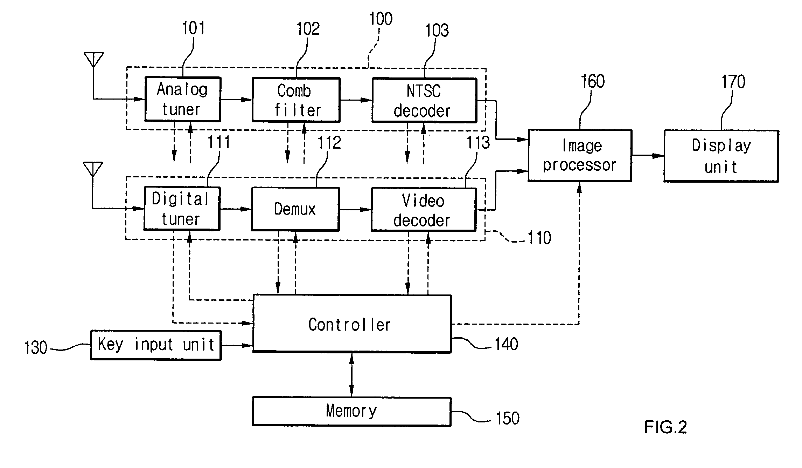

As shown in Fig. 2, an image display device comprises:
an analog signal processing unit 100 receiving an analog broadcasting signal to change into a signal to be displayed; a digital signal processing unit 110 receiving a digital broadcasting signal to change into a signal to be displayed; a key input unit 130 to which a command of a user is input; a controller 140 performing an automatic channel setting with reference to a channel information in accordance with an automatic channel setting command received through the key input unit 130 to selectively store a channel with an synchronous signal; an image processing unit 160 receiving an image signal processed through the analog signal processing unit 100 or the digital signal processing unit 110 in accordance with a control signal of the controller 140; and a memory 150 storing a channel information.

Here, the analog signal processing unit 100 comprises an analog tuner 101 tuning an analog channel; a comb filter 102 filtering a broadcasting signal of the tuned channel through the analog tuner 101; and a NTSC decoder 103 receiving a broadcasting signal filtered in the comb filter 102 to decode into an NTSC signal.

In addition, the digital signal processing unit 110 comprises: a digital tuner 111 tuning a digital channel; a demux 112 receiving a broadcasting signal of the tuned digital channel through the digital tuner 111 to divide into an video, a audio and additional information; a video decoder 113 receiving a divided video signal through the demux 112 for decoding.

Therefore, if an automatic channel setting command is received from the key input unit 130 by the user, the controller 140 outputs a control signal to a corresponding tuner so that a channel is tuned.

In other words, if the user enters an automatic channel setting command through the key input unit 130, an analog channel is tuned through the analog tuner 101 and a digital channel is tuned through the digital tuner 111.

The method for tuning the analog channel is to search for an synchronous signal with respect to a frequency corresponding to a channel to be currently tuned by an analog tuner 101, and to find if the synchronous signal is searched within the established corresponding frequency range to determine if a signal of a channel exists.

In the meantime, a broadcast signal received from the digital tuner 111 is transmitted in an error corrected digital stream type from VSB sync and a transport signal row standardized by an MPEG-2 method is transmitted in a transport stream packet type.

An error corrected digital stream is received from the VSB sync into the demux 112, and a stream having a PAT table information is searched for in the demux 112 to transmit a data into the controller 140 for configuring a table. The PMT table is configured and a VCT table is searched out of the streams having an address of Ox1FFB to determine if the currently received stream is a PSIP stream and a stream configuring an EIT table is searched for to configure an EIT table. In addition, a channel number of a VCT table is extracted to find a real channel number of RF channel being a major-minor channel number.

On the other side, a stream having a standard in accordance with an MPEG-2 system has a header at a start portion of a packet, and the header has a Packet Identifier PID number.

The PID number can be used as information for demultiplexing time-multiplying signal. In addition, the PID number shows kinds of a current packet and analyzes a PID number to detect if the current packet is an video packet, a audio packet and a program specific information. In other words, a PAT having a PID information of PMT, PMT having a program number information in the current RF channel digital stream and an EIT having a detailed information of each program are included. However, a digital stream consisting of PAT/PMT does not have a channel number in a major-minor type, but the number of a program in a digital stream and video/audio PID information of each program. In other words, a major channel number uses a RF channel number where a digital stream is input, and a minor number uses a program number of PMT.

The controller 140 performs a channel search with respect to an analog channel and a digital channel in accordance with an automatic channel setting command of the user to store a channel receiving a broadcasting signal (synchronous signal) in a memory 150.

Fig. 2 show an image display device including an analog signal processing unit 100 and a digital signal processing unit 110, but the present invention is not limited to an image display device including the analog signal processing unit 100 and the digital signal processing unit 110.

For example, the present invention can be applied to an image display device including an analog signal processing unit 100 or an image display device including a digital signal processing unit 110.

In the case that the user performs an automatic channel setting and inputs a deletion command with respect to a channel stored in the memory 150, a corresponding channel is deleted and deletion information showing that the corresponding channel has been deleted is stored in the memory 150.

Even if a synchronous signal is detected in the next automatic channel setting process with reference to deletion information stored in the memory 150, a channel having deletion information is not stored but skipped, thereby preventing an undesired channel from being stored in the automatic channel setting process again.

In other words, if the automatic channel setting command is input, the controller 140 confirms channel information meaning a deleted channel is stored in the memory 150 and perform a channel storing with respect to a channel receiving broadcast information except the corresponding channel.

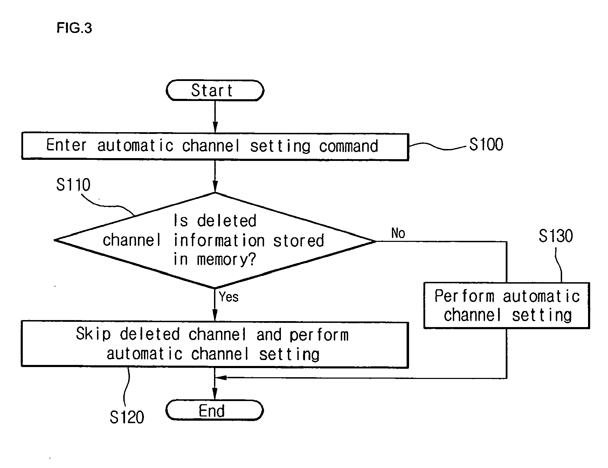

Fig. 3 is a view describing the first embodiment of a channel setting method.

First, if an automatic channel setting command is input by the user, a controller determines if information with respect to a deleted channel is stored in a memory. (S100) (S110)

In an automatic channel setting process, a channel having deletion information in a memory does not perform a channel storing but determines if a broadcasting signal (synchronous signal) is input only with respect to a channel without a deletion information and performs channel storing. (S120)

In the case where deletion information is not stored in a memory, a broadcast signal (synchronous signal) input with respect to all channels is determined to perform an automatic channel setting. (S130)

However, a previously deleted channel is not stored in accordance with deletion information of a channel stored in a memory before the automatic channel setting is performed, but the user is consulted if an automatic channel setting is performed on an OSD screen, and a channel search can be performed with respect to a deleted channel in accordance with a selection of the user.

In the meantime, if an image display device is reset or if channel information of an image display device is reset, channel information stored in the memory or deletion information stored in the memory can be deleted.

Therefore, if an image display device is reset or if automatic channel setting is performed after an image display device is reset, a channel receiving a broadcasting signal with respect to all channels is stored.

In this way, the present invention stores a channel with respect to a part of channel s receiving a broadcasting signal with reference to a channel information in an automatic channel setting process to prevent unnecessary channels from being stored.

At this time, automatic channel setting is not performed with respect to all channels, but automatic channel setting may be performed with respect to some channels in accordance with the kinds of an image display device or a selection of a user. In this case, channel storing is performed with respect to a channel receiving other broadcast signals except channels including deletion information (channel information) out of some channels performing an automatic channel setting.

For example, automatic channel setting may be performed only with respect to a digital channel, and a channel storing is performed with respect to channels receiving a broadcasting signal out of channels without deletion information with reference to channel information of a memory.

In this way, automatic channel setting may be performed with respect to a channel group selected out of a channel group divided in accordance with a genre of a broadcasting program, for example, a movie channel, a news channel and a sports channel. In this case, channel storing may be performed with respect to some channels out of channels receiving a broadcast signal with reference to channel information of a memory.

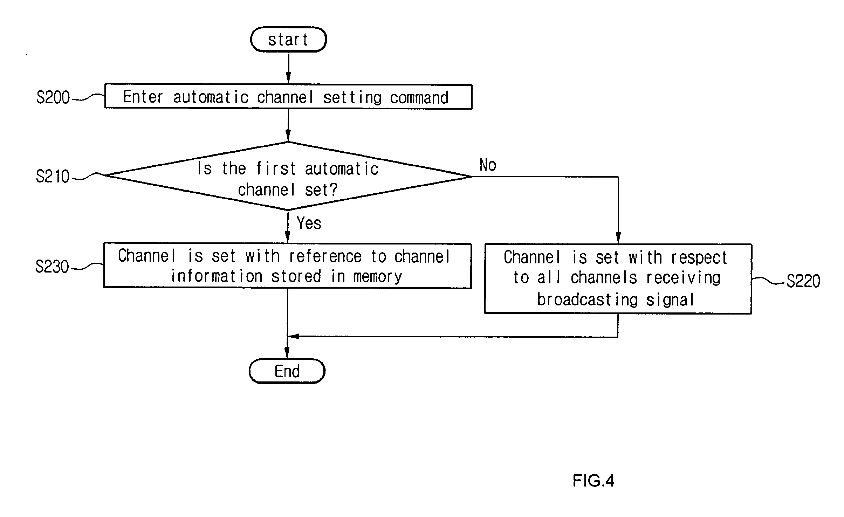

Fig. 4 is a view describing the second embodiment of a channel setting method in accordance with the present invention.

First, it is determined if the automatic channel setting command is the first automatic channel setting. (S200)

The automatic channel setting command is determined if it is the first automatic channel setting. (S210)

If the automatic channel setting command is the first automatic channel setting, a part of channels receiving a broadcast signal with reference to a channel information as shown in Fig. 3. (S230)

If the automatic channel setting command is not the first automatic channel setting (referred to the second automatic Channel setting), channel storing is performed with respect to all channels receiving a broadcast signal as in the prior art. (S220)

In other words, two methods of automatic channel setting are suggested in the second embodiment of a channel setting method as shown in Fig. 4, channel storing is performed with reference to channel information if the first automatic channel setting is selected and channel storing is performed with reference to all channels receiving a broadcast signal if the second automatic channel setting is selected.

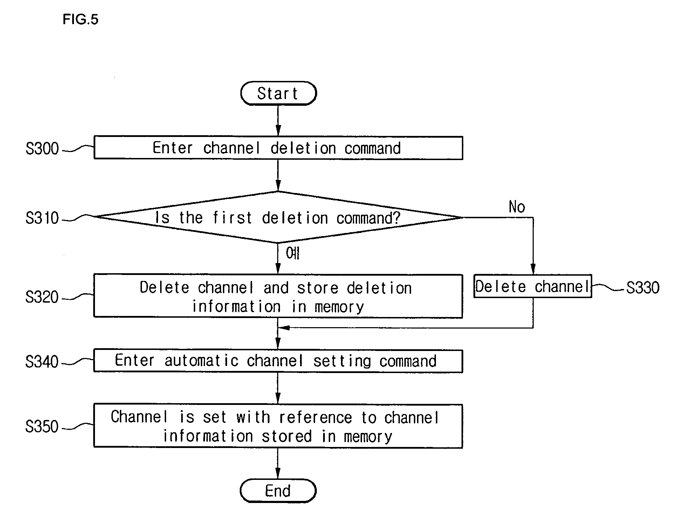

Referring to the third embodiment of Fig. 5, if unnecessary channels exist during a channel up/down, a channel deletion command is entered. (S300)

The channel deletion command is determined to be the first deletion command. (S310)

If the channel deletion command is the first deletion command, the selected channel is deleted and channel information (deletion information meaning that it has been deleted) is stored in a memory (S310) (S320)

If the channel deletion command is not the first deletion command (referred to as the second deletion command), channel information is not stored in a memory to delete a selected channel. (S330) Deletion information may be stored even if a second command is deleted depending on a setting. However, a deleted second deletion command is stored to be divided from the second deletion command.

If an automatic channel setting command is entered, channel storing is performed with reference to channel information stored in a memory. (S340) (S350)

In this case, if a channel is deleted by the first deletion command, deletion information is stored in a memory, and channel storing is not performed in receiving a broadcasting signal. If a channel is deleted by the second deletion command, deletion information is not stored in a memory and a channel storing is performed with respect to all channels receiving a broadcasting signal.

In other words, two methods of channel deletion are suggested in the third embodiment of a channel setting method as shown in Fig. 5, channel storing is changed depending on a method of a channel deletion during an automatic channel setting.

For example, in a case of an automatic channel setting, and a deleted channel being deleted by the first deletion command, channel storing is not performed as shown in Fig. 3. If a deleted channel is deleted by a second deletion command, all channels receiving a broadcast signal are stored as in the prior art.

In this way, embodiments of the present invention can store deletion information if a stored channel is deleted, and a channel having deletion information is not stored but skipped in the succeeding automatic channel setting process.

Therefore, unnecessary channels are stored in an automatic channel setting process to avoid the inconvenience of deleting them again.

## Claims

1. A channel setting device comprising:
a signal processing unit including a tuner arranged to perform a channel search;
a key input unit arranged to receive as input a request command of a user;
a memory arranged to store channel information; and
a controller arranged to control channel setting with reference to channel information stored in the memory in performing an automatic channel setting in accordance with the automatic channel setting command of the key input unit.

2. The channel setting device of claim 1, wherein the channel information is deletion information identifying a deleted channel.

3. The channel setting device of claim 2, wherein the controller is arranged not to store channels having deletion information but to store channels not having a deletion information out of these channels receiving broadcast signals during automatic channel setting.

4. The channel setting device of claim 2, wherein the controller arranged not to store channels having deletion information deleted by the first deletion command but to store channels having deletion information deleted by the second deletion command or a channel without a deletion information.

5. A channel setting method comprising:
inputting an automatic channel setting command;
searching for channel information stored in a memory in accordance with the automatic channel setting command; and
performing a channel setting with reference to the channel information.

6. The method of claim 5, wherein the channel information is deletion information identifying a deleted channel.

7. The method of claim 6, wherein the channel setting does not store channels having deletion information but stores channels not having deletion information out of these channels receiving broadcast signals during automatic channel setting.

8. The method of claim 6, wherein the channel setting does not store channels having deletion information deleted by the first deletion command but stores channels having deletion information deleted by the second deletion command or a channel without a deletion information.

9. A channel setting device comprising:
a signal processing unit having a tuner arranged to perform a channel search;
a key input unit arranged to receive a request command of a user; and
a controller arranged to perform channel storing with reference to channel information in accordance with an automatic channel setting method in performing an automatic channel setting according to a signal of the key input unit.

10. The device of claim 9, wherein the channel information is deletion information identifying a deleted channel.

11. The device of claim 10, wherein the controller is arranged to perform channel storing with respect to channels without deletion information out of channels having a broadcast signal in the case that the selected automatic channel setting method is the first automatic channel setting, and if the selected automatic channel setting method is the second automatic channel setting, to perform channel storing with respect to all channels having a broadcast signal.

12. A channel setting method comprising:
receiving an automatic channel setting command;
determining if the automatic channel setting command is the first automatic channel setting; and
performing channel setting with reference to channel information stored in a memory if the automatic channel setting command is the first automatic channel setting, and performing a channel setting with reference to all the channels receiving a broadcasting signal if the automatic channel setting command is not the first automatic channel setting.

13. The method of claim 12, wherein the channel information is deletion information identifying a deleted channel.

14. The method of claim 12, wherein deleted information identifying a deleted channel is searched for out of channel information if the automatic channel setting command is the first automatic channel setting, and no channel storing is performed of channels identified as deleted.

15. A channel setting method comprising:
receiving an automatic channel setting command performing an automatic channel setting with respect to some channels out of all possible settable channels;
searching for channel information stored in a memory in accordance with the automatic channel setting command;
performing channel setting with reference to the channel information with respect to a channel receiving a broadcasting signal out of some channels.

16. The channel setting method of claim 15, wherein some channels are groups divided in accordance with a genre of a broadcasting program of all the setting possible channels.

17. The channel setting method of claim 15, wherein the channel information is deletion information identifying a deleted channel.

18. The channel setting method of claim 15, wherein the channel information includes deletion information identifying a deleted channel, and does not store a channel having deletion information out of channels receiving a broadcast signal but stores channels without deletion information.

19. A channel setting method comprising:
receiving an automatic channel setting command; and
determining if channel information and broadcast information stored in a memory in accordance with the automatic channel setting command so as to store a selected channel out of channels having a broadcast signal.

20. The channel setting method of claim 19, wherein the channel information is deletion information identifying a deleted channel.
